# EUROPÄISCHE PATENTSCHRIFT

(11) **EP 1 961 281 B1**
(45) Veröffentlichungstag und Bekanntmachung des Hinweises auf die Patenterteilung: **14.10.2009**
(21) Anmeldenummer: 06829353.9
(22) Anmeldetag: 06.12.2006
(51) Int. Cl.: H05K 7/14, H05K 7/20

(54) **GERÄT, BAUREIHE VON GERÄTEN, VORRICHTUNG MIT GEHÄUSETEILEN, VERFAHREN, VERWENDUNG EINES LUFTKÜHLERS UND VERWENDUNG EINES FLÜSSIGKEITSKÜHLERS**
APPLIANCE, SERIES OF APPLIANCES, DEVICE COMPRISING HOUSING PARTS, METHOD, USE OF AN AIR COOLER, AND USE OF A LIQUID COOLER
APPAREIL, SERIE D'APPAREILS, DISPOSITIF COMPRENANT DES PARTIES DE BOITIER, PROCEDE, UTILISATION D'UN REFROIDISSEUR A AIR ET UTILISATION D'UN REFROIDISSEUR A LIQUIDE

(30) Priorität: 08.12.2005 DE 102005059017
(43) Veröffentlichungstag der Anmeldung: 27.08.2008
(73) Patentinhaber: SEW-EURODRIVE GmbH & Co. KG, 76646 Bruchsal (DE)
(72) Erfinder: MARAHRENS, Klaus, 76337 Waldbronn-Reichenbach (DE); KOLLAR, Hans, Jürgen, 76646 Bruchsal (DE); GRAMM, Werner, 76646 Bruchsal (DE); NIKOLA, Joachim, 76703 Kraichtal (DE); MERTZLUFFT-PAUFLER, Cornelius, 79102 Freiburg im Breisgau (DE)
(74) Vertreter: Tüngler, Eberhard
(86) Internationale Anmeldenummer: PCT/EP2006/011725
(87) Internationale Veröffentlichungsnummer: WO 2007/065666

(56) Entgegenhaltungen:
- WO-A-20/06021358
- DE-A1- 10 236 525
- DE-U1- 20 200 484
- JP-A- 8 186 388
- US-A1- 2006 227 504

## Beschreibung

Die Erfindung betrifft ein Gerät, ein Verfahren und eine Verwendung eines Luftkühlers und eine Verwendung eines Flüssigkeitskühlers.

Aus der DE 198 47 789 ist ein Umrichter als Gerät mit Luftkühler bekannt. Dabei weist die als Luftkühler ausgeführte Kühlvorrichtung Kühlrippen auf. Die Leistung des Geräts ist dabei begrenzt durch die Wärmeabfuhrleistung der Kühlvorrichtung.

Aus der DE 102 36 525 A1 ist ein Ventilbauelement-Satz bekannt, bei dem IGBT-Module und Kondensatoren über ein Schienensystem elektrisch leitfähig verbunden sind, wobei die IGBT-Module gemeinsam mit Heizstäben auf einem Kühlkörper angebracht sind, der Rippen aufweist, an denen Luft zur Kühlung vorbeiströmt.

Aus der DE 202 00 484 U1 ist eine Kühlvorrichtung für Bauteile bekannt, bei der ein von einem Kühlmittel durchströmten Wärmetauscher vorgesehen ist

Aus der DE 43 22 647 A1 ist ein Kühlkörper bekannt, der aus zwei Profilen erstellt ist, die kammartig ineinander greifen.

Aus der DE 20 2004 017 950 U1 ist eine Montageplatte für elektronische Bauteile bekannt, die einen von Kühlflüssigkeit durchströmten Kühlkörper umfasst, wobei eine Schraubenmutter zur Ausbildung einer Schraubverbindung mit einem elektronischen Bauteil verdrehsicher in eine sich am Kühlkörper erstreckende Befestigungseinrichtung einführbar ist.

Aus der DE 199 08 160 A1 ist eine elektronische Baugruppenanordnung bekannt, die einen prozessor und einen Energieversorgungsbaustein umfasst, welche durch einen gemeinsamen Träger zusammengehalten werden, an den ein Lüfter montierbar ist.

Aus der JP 08 186388 A ist ein elektrisches Gerät bekannt, bei dem ein Luftkühler (fins 2a) vorgesehen ist, an dem ein Flüssigkeitskühler (cooling pipe 8) anmontiert ist.

Aus der WO 2006 / 021358 A ist ebenfalls ein elektrisches Gerät bekannt, bei dem ein Kühlkörper (16) vorgesehen ist, an dem ein Flüssigkeitskühler (Flüssigkeitskühlungseinrichtung 40) anmontiert ist.

Der Erfindung liegt die Aufgabe zugrunde, eine Baureihe von Geräten mit hoher Leistungsdichte aber geringen Kosten weiterzubilden.

Erfindungsgemäß wird die Aufgabe bei dem elektrischen Gerät nach den in Anspruch 1, bei dem Verfahren nach den in Anspruch 19 und bei der Verwendung nach den in Anspruch 20 bis 15 angegebenen Merkmalen gelöst.

Wichtige Merkmale bei der Erfindung eines elektrischen Geräts sind, dass Wärme erzeugende elektrische Komponenten, insbesondere Leistungshalbleiter, und eine Kühlvorrichtung zur Abfuhr dieser Wärme umfasst sind, wobei die Kühlvorrichtung aus einem Luftkühler gebildet ist, an dem ein Flüssigkeitskühler anmontiert ist und wobei der Luftkühler zwischen dem Flüssigkeitskühler und den Wärme erzeugenden elektrischen Komponenten vorgesehen ist. Wichtige Merkmale der Erfindung bei dem Gerät sind außerdem, dass das Gerät Wärme erzeugende Komponenten und eine Kühlvorrichtung zur Abfuhr dieser Wärme umfasst, wobei die Kühlvorrichtung wahlweise luftbetrieben oder flüssigkeitsbetrieben, wie beispielsweise wasserbetrieben, ausgeführt ist. Beispiele für Wärme erzeugende Komponenten sind Leistungshalbleiter, Widerstände, insbesondere Bremswiderstände, und andere elektronische Bauelemente mit großer Wärmeentwicklung, beispielsweise Spulen. Von Vorteil ist bei der Erfindung, dass das Gerät bei kleiner Leistungsanforderung ohne Wasserkühlung und bei hoher Leistung mit zusätzlich gleichzeitiger Wasserkühlung ausstattbar ist. Somit ist innerhalb einer Baureihe eine Grundvariante und eine Zusatzvariante herstellbar. Es ist sozusagen ein Baukastensystem erreicht, wobei je nach Anwendung, also der Anlage und ihrer Anforderungen ans Gerät, eine hohe Leistung abgebbar ist oder das Gerät luft- und/oder flüssigkeitsgekühlt betreibbar ist. Als Beispiel für Flüssigkeit wird im Folgenden Wasser verwendet.

Unter Wasserkühler ist stets auch Flüssigkeitskühler mitzulesen und unter Luftkühler stets Gaskühler.

Bei einer vorteilhaften Weiterbildung umfasst der Luftkühler einen Kühlkörper, der Rippen und/oder Finger aufweist zur Wärmeabgabe an vorbeiströmende Luft, und die Wärme erzeugenden elektrischen Komponenten sind auf, in oder an einer Grundplatte verbunden, insbesondere wärmeleitend, wobei die Grundplatte mit dem Kühlkörper einstückig ausgebildet ist, und der Kühlkörper weist eine mechanische Schnittstelle zum lösbaren Verbinden mit einem Flüssigkeitskühler auf. Somit ist bei dem Kühlkörper kein Wärmeübergang zwischen zwei Teilen notwendig sondern die Wärme breitet sich innerhalb des einen Teils aus, insbesondere bis in die Kühlfinger oder Kühlrippen. Bei der Erfindung ist nun von besonderem Vorteil, dass der Flüssigkeitskühler an den Luftkühler, umfassend Grundplatte und Kühlrippen, verbindbar ist. Somit sind also drei Betriebsarten ermöglicht: erstens Luftkühlung mit bloßem Luftkühler, zweitens bei verbundenem Wasserkühler eine Kühlung nur durch diesen und drittens bei verbundenem Wasserkühler eine Kühlung durch Luftkühler und Wasserkühler. Bei der zweiten Variante wird Wärme nicht an die Umgebungsluft abgegeben. Die einstückige Ausbildung von Grundplatte mit Kühlkörper hat den zusätzlichen Vorteil gegenüber einer Austauschbarkeit von Luftkühler gegen Wasserkühler, dass eine lösbare Schnittstelle oder Wärmeübergangsstelle zwischen Wärme erzeugenden elektrischen oder elektronischen Komponenten und Luftkühler vermeidbar ist. Dadurch ist die Kühlleistung des Luftkühler im Betrieb ohne Wasserkühler erheblich erhöht gegenüber einem Luftkühler mit derartiger Schnittstelle. Insbesondere die Vermeidung von Schnittstellen oder Materialgrenzen besonders vorteilhaft bei der Verbesserung der Kühlleistung eines Luftkühlers, bei dem ja die Wärmeabgabe an die Umgebungsluft von sich aus ungünstig ist.

Bei einer vorteilhaften Ausgestaltung ist die Grundplatte mit den Kühlrippen oder mit Kühlfingern einstückig ausgebildet ist. Wesentlich ist dabei, dass der Kühlkörper einstückig ausgebildet ist und somit möglichst wenig, nämlich keinen, Wärmeübergang aufweist. Es sind also nur Wärmeübergänge von den Wärme erzeugenden Komponenten zum Luftkühler vorhanden. Bei zusätzlich anmontiertem Wasserkühler ist auch noch ein Wärmeübergang vom Luftkühler zum Wasserkühler vorhanden.

Bei einer vorteilhaften Weiterbildung umfasst die mechanische Schnittstelle eine Bodenplatte zur Montage des Flüssigkeitskühlers. Bei einer vorteilhaften Weiterbildung ist an der Bodenplatte ein Wasserkühler montiert. Von Vorteil ist dabei, dass mit einer Bodenplatte eine einfach fertigbare Schnittstelle definiert ist, die einen guten Wärmeübergang zum Wasserkühler sorgt, insbesondere durch die Ausbildung einer ebenen Kontaktfläche, die hinreichende Festigkeit zur Befestigung des Wasserkühlers bewirkt.

Bei einer vorteilhaften Ausgestaltung ist am Kühlkörper ein Wasserkühler lösbar verbindbar. Von Vorteil ist dabei, dass wahlweise ein Wasserkühler zusätzlich verbindbar ist oder nicht.
Die Auswahl ist dabei abhängig von der angeforderten Leistungsdichte für das Gerät, also Leistung pro Volumen des Geräts. Die Wasserkühlung kann zusätzlich gleichzeitig zur Luftkühlung betrieben werden, oder es wird auch nur die Wasserkühlung betrieben. Mit zusätzlicher Wasserkühlung ist erheblich mehr Wärmeleistung abführbar als mit bloßer Luftkühlung.

Bei einer vorteilhaften Ausgestaltung umfasst das Gerät einen Kühlkörper, der Rippen oder Finger aufweist zur Wärmeabgabe an vorbeiströmende Luft. Von Vorteil ist dabei, dass eine große Oberfläche zur Abgabe von Wärme vorgesehen ist und somit die DurchschnittsTemperatur im Kühlkörper niedrig gehalten ist.

Bei einer vorteilhaften Weiterbildung umfasst der Wasserkühler eine Kühlerplatte, in der parallel verlaufende Kühlmittelkanäle ausgebildet sind, die vorzugsweise durch Anschlussteile und/oder Abschlussteile zu einem Kühlmittelkanalsystem verbunden sind, insbesondere wobei die Kühlmittelkanäle als Bohrung und/oder als Nut ausgebildet sind. Vorzugsweise ist der Wasserkühler mindestens dreiteilig ausgebildet, wobei als Mittelteil eine Kühlerplatte vorgesehen ist, in die vorteilhaft in einem einfachen Herstellungsverfahren parallel verlaufende Kühlmittelkanäle eingebracht sind. Der Wasserkühler umfasst weiter Anschlussteile, die diese Kühlmittelkanäle verbinden und somit den Wasserkühler zur Einbindung in einen Kühlmittelkreislauf bereitstellen. Diese Kühlmittelkanäle sind vorteilhaft in Reihe oder parallel verbindbar. Auch Kombinationen sind denkbar. In einer Weiterbildung sind statt der Bohrungen andere Profilquerschnitte, beispielsweise quadratische, vorsehbar, insbesondere wenn die Kühlerplatte im Stranggussverfahren gefertigt wird.

Bei einer vorteilhaften Weiterbildung umfasst der Wasserkühler eine Kühlerplatte, in der Ausnehmungen zur Aufnahme und/oder Durchleitung einer Kühlflüssigkeit ausgebildet sind, wobei die Bodenplatte des Luftkühlers zumindest teilweise gehäusebildend für die Ausnehmungen ist. Von Vorteil ist dabei, dass eine einfache Fertigung durchführbar ist. Denn aufwendige Bohrungen sind verzichtbar, vielmehr sind die Nuten als Druckguss herstellbar. Die Nuten sind dabei vorteilhaft so angeordnet, dass in Idealisierung ein planarer Graph gebildet wird. Durch den unmittelbaren Kontakt zwischen Kühlflüssigkeit und Bodenplatte des Luftkühlers ist der Wärmeabfluss von den Wärme erzeugenden Komponenten, also die Kühlleistung, weiter verbessert.

Bei einer vorteilhaften Weiterbildung sind statt der oder zusätzlich zu den Nuten Ausnehmungen anderer geometrischer Form ausgebildet, die zur Aufnahme und Durchleitung von Kühlflüssigkeit geeignet sind. Auch in diesem Fall ist ein Teil der Bodenplatte des Luftkühlers zumindest teilweise gehäusebildend für die Ausnehmungen, und es sind durch Aufsetzen des Wasserkühlers Kühlmittelkanäle gebildet. Beispiele alternativer geometrischer Formen umfassen kreisförmige Ausnehmungen, rechteckige Ausnehmungen und unregelmäßige Ausnehmungen mit mehr oder weniger starken Verästelungen.

Bei einer vorteilhaften Weiterbildung sind die Ausnehmungen der Kühlerplatte als mäanderförmige Nut ausgebildet, die in seitlich oder in der Rückwand der Kühlerplatte angebrachte Anschlussvorrichtungen, insbesondere Anschlussstutzen, zum Anschluss an eine Kühlmittelanlage münden. Eine mäanderförmige Nut bewirkt vorteilhaft einen guten Wärmeübergang von der Kühlerplatte an das Kühlmittel.

Bei einer vorteilhaften Weiterbildung weist die Bodenplatte Erhebungen auf, die zu den Ausnehmungen der Kühlerplatte passend ausgebildet sind, insbesondere zum dichtenden Abschluss der Ausnehmungen und/oder als Zentrierhilfe. Die Erhebungen bewirken vorteilhaft ein Aufwirbelung der Kühlflüssigkeit beim Vorbeiströmen und damit eine gute Durchmischung der Kühlflüssigkeit. Somit ist die Wärmeaufnahme durch die Kühlflüssigkeit verbessert und die Kühlflüssigkeit optimal ausgenutzt.

Bei einer vorteilhaften Weiterbildung ist die Bodenplatte über die Kühlnppen und/oder Kühlfinger von der Grundplatte beabstandet ausgebildet. Von Vorteil ist dabei, dass die Kühlrippen und/oder Kühlfinger in einer zweiten und dritten Funktion verwendbar sind, nämlich zur Wärmeanbindung und zur mechanischen Anbindung eines Wasserkühlers.

Bei einer vorteilhaften Weiterbildung sind an der Grundplatte des Kühlkörpers einerseits kühlrippen und/oder Kühlfinger ausgebildet und andererseits ist an der Grundplatte eine Bodenplatte zum Herstellen einer Verbindung mit der Bodenplatte vorgesehen, wobei Bodenplatte und Grundplatte einstückig ausgebildet sind. Von Vorteil ist dabei, dass eine alternative Baugeometrie bereitgestellt ist, bei welcher die Bodenplatte besonders robust mit der Grundplatte verbunden ist. Somit ist vorteilhaft eine sichere Befestigung des Wasserkühlers an dem Luftkühler bewirkt, und die Kühlfinger und/oder Kühlrippen sind mechanisch entlastet und vorteilhaft filigran ausbildbar.

Bei einer vorteilhaften Weiterbildung ist die Grundplatte mit den Kühlrippen oder mit Kühlfingern einstückig ausgebildet. Somit ist der Wärmeübergang von den Wärme erzeugenden Komponenten an die Kühlfinger ohne vermeidbare Materialgrenzen ausgebildet. Allgemein ist ein Vorteil der Erfindung, dass verschiedene Materialgrenzen verzichtbar sind und dennoch eine hohe Variantenvielfalt unter den konfigurierbaren Kühlvorrichtungen bei verhältnismäßig geringem Teileaufwand erreicht wird. Besonders vorteilhaft ist, dass die Kühlleistung durch die modulare Bauweise nachträglich, das heißt nach Aufbau des Geräts, durch eine einfache Nachrüstung erhöht werden kann.

Bei einer vorteilhaften Weiterbildung ist zwischen Wasserkühler und Kühlkörper Wärmeleitpaste oder Wärmeleitfolie vorgesehen. Von Vorteil ist dabei, dass der Wärmeübergangswiderstand verringerbar ist. Als Materialien seien hier vorzugsweise Graphit oder Aluminiumwachsbeschichtung oder dergleichen genannt.

Bei einer vorteilhaften Weiterbildung sind die mechanische Schnittstelle und die Mittel zum Verbinden derart ausgeführt, dass Wasserkühler und Kühlkörper an der Berührfläche im Wesentlichen eben anliegend verbindbar sind. Somit ist ein besonders guter Wärmeübergang erreicht, und es wird eine hohe Kühlleistung bereitgestellt.

Bei einer vorteilhaften Ausgestaltung sind die mechanische Schnittstelle und die Mittel zum Verbinden derart ausgeführt, dass Wasserkühler und Kühlkörper an der Berührfläche im Wesentlichen eben anliegend verbindbar sind. Von Vorteil ist dabei, dass der Wärmeübergang lückenlos, insbesondere ohne Luftlöcher oder dergleichen, ausführbar ist.

Bei einer vorteilhaften Weiterbildung umfassen die Mittel zum Verbinden Spannelemente. Von Vorteil ist dabei, dass ein schnelles, einfaches Verbinden des Wasserkühler vornehmbar ist. Insbesondere ist ein Andrücken des Wasserkühlers an die Bodenplatte des Kühlkörpers ermöglicht. Dieses Andrücken ist dabei so ausgeführt, dass die Spannelemente ein möglichst gleichmäßiges Anliegen bewirken.

Bei einer vorteilhaften Weiterbildung ist der Kühlkörper und/oder die Kühlerplatte als Strangpressprofil oder Druckguss fertigbar. Somit ist eine einfache Fertigung der Kühlerplatte und/oder des Kühlkörpers durchführbar. Außerdem sind die Hohlräume entlang der Ziehrichtung oder Pressrichtung ausgerichtet und somit in dieser Richtung von Luft und/oder Kühlmittel durchströmbar.

Bei einer vorteilhaften Weiterbildung umfasst der Kühlkörper Kühlrippen zwischen einer Grundplatte und einer Bodenplatte, welche zur Verbindung mit dem Wasserkühler vorgesehen ist. Von Vorteil ist dabei, dass eine kompakte Bauform bereitgestellt ist. Außerdem ist von Vorteil, dass die Wärme von der Grundplatte über die Kühlrippen an die Bodenplatte transportierbar ist und dabei entweder an die an den Rippen vorbeiströmende Luft abgebbar ist oder von der Bodenplatte weiter abtransportierbar ist mittels der berührend angeordneten Wasserkühlung, wobei im Bereich der Berührung Wärmeleitpaste vorsehbar ist.

Alternativ wird der Kühlkörper mit Kühlfingern statt Kühlrippen ausgestattet. Verteilhaft ist dann eine isotrope Kühlfähigkeit erreichbar, es ist also keine Vorzugsrichtung, insbesondere für konvektiv strömende Kühlluft vorhanden.

Bei einer vorteilhaften Weiterbildung umfasst der Kühlkörper Kühlrippen auf einer Grundplatte, an der eine Bodenplatte angebracht oder einstückig ausgeformt ist, welche zur Verbindung mit dem Wasserkühler vorgesehen ist. Von Vorteil ist dabei, dass die Wärme von der Grundplatte über die Kühlrippen an die Luft transportierbar ist, wobei die Bodenplatte seitlich angeordnet ist. Somit sind andere relative Anordnungen des Wasserkühlers ermöglicht. Von Vorteil ist dabei weiter, dass eine alternative Baugeometrie bereitgestellt ist, bei der die Bodenplatte den Konvektionsstrom der Luftkühlung nicht beeinträchtigt. Somit ist ein derartiger Kühlkörper über einen großen Leistungsbereich als ausschließlicher Luftkühler einsetzbar.

Bei einer vorteilhaften Ausgestaltung ist ein Lüfter zum Erzeugen von Luftströmung entlang der Rippen des Kühlkörpers vorgesehen. Von Vorteil ist dabei, dass der Wärmeübergang von den Rippen an die durchströmende Luft verbessert werden kann bei luftgekühlter Kühlungsbetriebsart. Bei Einsatz der wasserkühlenden Betriebsart ist die warme Umgebungsluft an den Rippen vorbeigeführt und gibt ihre Wärme an diese Rippen ab, welche die Wärme dann an den noch kälteren Wasserkühler weiterleiten.

Bei einer vorteilhaften Weiterbildung ist das Gerät in einem geschlossenen Raumbereich vorgesehen, so dass Wärme aus der Luft des Raumbereiches zusammen mit der Wärme der Komponenten über die Rippen und den Wasserkühler abführbar ist. Von Vorteil ist dabei, dass das Gerät unter Bedingungen einsetzbar ist, bei denen die das Gerät umgebende Luft wärmer ist als die Rippen oder zumindest ein wesentlicher Teil der Rippen. Somit wird die Wärme dann abtransportiert an die Bodenplatte und von dort an den Wasserkühler.

Bei einer vorteilhaften Weiterbildung sind im Raumbereich weitere Geräte angeordnet, die an die Luft des Raumbereiches Wärme abgebende Komponenten aufweisen. Von Vorteil ist dabei, dass andere Geräte vom ersten Gerät indirekt kühlbar sind. Dies hat zum Vorteil, dass der Raumbereich der Vorrichtung, etwa das Innere eines Schaltschranks, Wärme aufnimmt in seiner Luft. Die Wärme ist dann abführbar über die Rippen und den Wasserkühler des Geräts. Ein anderer Teil der Wärme der Luft des Raumbereichs wird aber auch über das Gehäuse der Vorrichtung an deren Umgebung abgeführt. Somit muss nicht die gesamte Wärme über das Gerät mit Wasserkühler abgeführt werden.

In Weiterbildung umschließt die Vorrichtung mit ihren Gehäuseteilen einen Raumbereich, innerhalb dessen Wärme erzeugende Geräte angeordnet sind, wobei die Wärme oder ein Teil der Wärme an die vom Raumbereich umschlossene Luft abgebbar ist, wobei mindestens eines der Geräte einen Wasserkühler umfasst, der wärmeleitend mit Kühlrippen der Kühlvorrichtung des Geräts, insbesondere eines Luftkühlers des Geräts, lösbar verbindbar ist. Insbesondere ist die Vorrichtung ein Schaltschrank. Von Vorteil ist dabei, dass mit dem Gerät auch weitere Schaltschrankgeräte kühlbar sind, sobald die Luft im Schaltschrank wärmer ist als die Durchschnittstemperatur der Rippen.

Bei einer vorteilhaften Weiterbildung umfasst das Gerät Signalelektronik, die derart ausgeführt ist, dass Wärme von der Signalelektronik an den umgebenden Raumbereich abgebbar ist. Von Vorteil ist dabei, dass auch die Signalelektronik über den Wasserkühler kühlbar ist, obwohl hierzu nur die Umgebungsluft und keine speziellen weiteren Mittel zur Wärmestromlenkung notwendig sind.

Bei einer vorteilhaften Weiterbildung ist das Gerät ein Umrichter, der Signalelektronik und Leistungselektronik zur Versorgung eines Elektromotor umfasst. Von Vorteil ist dabei, dass in einem Gehäusetyp eines Umrichters verschiedene Leistungsklassen mit unterschiedlicher Wärmeentwicklung vorsehbar sind, und dass an das Gehäuse, dass teilweise mit Kühlfunktion versehen ist, je nach Bedarf ein zusätzlicher Wasserkühler montierbar ist.

Bei einer vorteilhaften Ausgestaltung ist das Gerät ein Elektrogerät, wie beispielsweise unterbrechungsfreie Stromversorgung, Frequenzumformer oder Umrichter, der Signalelektronik und Leistungselektronik zur Versorgung eines Elektromotors umfasst. Von Vorteil ist dabei, dass die Leistung pro Volumen bei Anmontieren des Wasserkühlers sehr hoch ausführbar ist.

Bei einer vorteilhaften Ausgestaltung ist das Gerät eine Steuerung, ein Umrichter, ein Sanftanlaufgerät, ein Motorstarter, oder weist eine Motorströme schaltende oder beeinflussende Elektronik auf, wobei das Gerät Signalelektronik und Leistungselektronik umfasst. Von Vorteil ist dabei, dass auch andere Geräte zum Beeinflussen des' Energieflusses verwendbar sind.

Bei einer vorteilhaften Weiterbildung weist das Gerät eine Steuerung, einen Umrichter, ein Sanftanlaufgerät, eine unterbrechungsfreie Stromversorgung, ein Notstromaggregat oder ein Frequenzumformer, einen Motorstarter oder allgemein eine Motorströme schaltende oder beeinflussende Elektronik auf, wobei das Gerät Signalelektronik und Leistungselektronik umfasst. Von Vorteil ist dabei, dass die Erfindung nutzbar ist in einem Anwendungsgebiet, in dem hohe Wärmeentwicklung typisch ist.

Bei einer vorteilhaften Weiterbildung umfasst die Grundplatte zusätzlich Verbindungsmittel zur formschlüssigen Verbindung mit Gehäuseteilen, insbesondere auch zum Abführen von einem Anteil der Wärme an die Umgebung über diese Gehäuseteile. Von Vorteil ist dabei, dass das Gerät als Teil eines Baukastens für Antriebssysteme ausführbar ist.

Wichtige Merkmale bei der Erfindung einer Baureihe sind, dass Varianten vorgesehen sind, wobei die Varianten der Baureihe jeweils ein elektrisches Gerät, insbesondere nach mindestens einem der vorangegangenen Ansprüche, umfassen, wobei
- in einer ersten Variante der Baureihe das elektrische Gerät mit einem Luftkühler vorgesehen ist,
- und in einer zweiten Variante der Baureihe das elektrische Gerät mit einem Flüssigkeitskühler betreibbar ist, der an dem Luftkühler anmontiert ist.

Von Vorteil ist dabei, dass wahlweise der Wasserkühler zur Erhöhung der Leistungsdichte des Gerätes anmontierbar ist oder nicht. Somit sind mit einem einzigen kleinen Zusatzteil, nämlich dem Wasserkühler, zwei Varianten der Baureihe mit verschiedener Leistung herstellbar. Insgesamt sind aber drei Betriebsarten ermöglicht. In einer ersten wird nur der Luftkühler betrieben, in einer zweiten wird nur der an den Luftkühler anmontierte Wasserkühler betrieben, wobei die Wärme über den Kühlkörper des Luftkühlers zum Wasserkühler strömt, und in einer dritten Betriebsart werden beide Kühler betrieben zur Erhöhung der Kühlleistung oder insbesondere um die das Gerät umgebende Luft abzukühlen.
Bei einer vorteilhaften Weiterbildung ist je nach geforderter Leistungsdichte das Gerät mit zur Luftkühlung zusätzlicher Wasserkühlung ausstattbar, wobei der Luftkühler eine mechanische Schnittstelle zum lösbaren Verbinden mit einem Wasserkühler aufweist.

Bei einer vorteilhaften Weiterbildung ist in einer Variante der ersten und zweiten Variante jeweils ein Lüfter an den Luftkühler montierbar: Somit ist die Variantenvielfalt weiter vergrößert hinsichtlich der erreichbaren Kühlleistungsklassen.

Wichtige Merkmale bei der Erfindung einer Vorrichtung sind, dass Gehäuseteile einen Raumbereich umschließen, innerhalb dessen Wärme erzeugende elektrische Geräte angeordnet sind, wobei ein Teil der Wärme an die vom Raumbereich umschlossene Luft abgebbar ist, wobei mindestens eines der elektrischen Geräte einen Wasserkühler umfasst, der wärmeleitend mit Kühlrippen der Kühlvorrichtung des elektrischen Geräts, insbesondere eines Luftkühlers des elektrischen Geräts, lösbar verbindbar ist, insbesondere direkt oder indirekt über eine mit den Kühlrippen oder Kühlfingern verbundene Bodenplatte. Somit ist ein Wasserkühler zur indirekten Kühlung über die Luft des Raumbereichs nutzbar.

Bei einer vorteilhaften Weiterbildung ist die Vorrichtung ein Schaltschrank. Von Vorteil ist dabei, dass die kombinierte Kühlvorrichtung aus Luftkühler und Wasserkühler zusätzlich zur Kühlung des Schaltschrankinneren verwendbar ist.

Wichtige Merkmale der Erfindung eines Verfahren zur Kühlung eines Umrichters sind, dass der Umrichter zumindest einen Flüssigkeitskühler und einen Luftkühler und Leistungshalbleiter umfasst, wobei Wärme von den Leistungsbauelementen durch den Kühlkörper des Luftkühlers hindurchgeleitet wird zum Flüssigkeitskühler. Von Vorteil ist dabei, dass ein neuartiges Kühlverfahren für einen Umrichter beschrieben ist, wobei einerseits die Kühlung des Umrichters bei geringer Leistungsentwicklung über einen Luftkühler erfolgt und andererseits eine Möglichkeit zur Zuschaltung eines Wasserkühlers vorgesehen ist, die die Luftkühlung nicht beeinträchtigt.

Bei einer vorteilhaften Weiterbildung wird Kühlflüssigkeit Wasser verwendet. Von Vorteil ist dabei, dass eine kostengünstige Kühlflüssigkeit verwendbar ist.

Bei einer vorteilhaften Weiterbildung sind die Leistungshalbleiter auf, in oder an einer Grundplatte verbunden, die einstückig ausgeführt ist mit Kühlrippen oder Kühlfingern des Kühlkörpers, wobei Wärme sich zwischen Grundplatte und Kühlrippen oder Kühlrippen ohne Wärmeübergang ausbreitet. Von Vorteil ist dabei, dass die Kühlleistung.des Luftkühlers nicht durch vermeidbare Materialgrenzen vermindert wird.

Wichtige Merkmale der Erfindung einer Verwendung eines Luftkühlers sind, dass der Luftkühler eingesetzt wird als Wärmebrücke zwischen Wärme erzeugenden Komponenten und einem Flüssigkeitskühler, insbesondere wobei zwischen Luftkühler und Flüssigkeitskühler eine mechanische Schnittstelle zur lösbare Verbindung vorgesehen ist.

Von Vorteil ist dabei, dass der Luftkühler mit einer zweiten Funktion beaufschlagbar ist, nämlich dem thermischen Anbinden eines Wasserkühlers bei Bedarf.

Wichtige Merkmale der Erfindung einer Verwendung eines Luftkühlers sind, dass ein Gerät vorgesehen ist, insbesondere ein Umrichter, das einen Flüssigkeitskühler und Wärme erzeugende Komponenten, insbesondere Leistungshalbleiter, umfasst, wobei der Luftkühler Wärme hindurchleitet von den Wärme erzeugenden Komponenten, insbesondere Leistungsbauelementen, zum Flüssigkeitskühler. Von Vorteil ist dabei, dass Wärme von einem Umrichter je nach Leistungsentwicklung abführbar ist über einen Luftkühler oder einen Wasserkühler, wobei der Wechsel zwischen den Kühlverfahren durch einen einfachen Montageschritt vollziehbar ist.

Bei einer vorteilhaften Weiterbildung leitet der Luftkühler einen wesentlichen Anteil, insbesondere 90% oder mehr, oder den Gesamtteil der von den Wärme erzeugenden Komponenten aufgenommenen Wärme hindurch an den Flüssigkeitskühler. Von Vorteil ist dabei, dass der Wasserkühler eine effiziente Kühlung des Geräts bewirkt. Zusätzlich ist eine Erwärmung der Umgebungsluft, insbesondere bei einer Montage im Schaltschrank, vermeidbar.

Wichtige Merkmale der Erfindung einer Verwendung eines Flüssigkeitskühlers sind, dass der Flüssigkeitskühler an einem Luftkühler eines Geräts vorgesehen wird zur Erhöhung der Kühlleistung, insbesondere derart, dass der Luftkühler einen wesentlichen Anteil oder den Gesamtteil der von den Wärme erzeugenden Komponenten aufgenommenen Wärme hindurchleitet an den Flüssigkeitskühler.

Bei einer vorteilhaften Ausgestaltung des elektrischen Geräts sind die Wärme erzeugenden . Komponenten Leistungsmodule und/oder Leistungshalbleiter Von Vorteil ist dabei, dass Leistungselektronik vorsehbar ist, insbesondere auch, um große Leistungen zu steuern, wie Elektromotoren mit mehreren kW. Alternativ sind die Komponenten Bremswiderstände oder sie sind in Frequenzumformern oder unterbrechungsfreien Stromversorgungen eingesetzt. Die erfindungsgemäße Vorrichtung ist also ein Elektrogerät, welches zumindest Leistungsbauelemente umfasst, die gekühlt werden über einen Kühlkörpers.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder eirizelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

### Bezugszeichenliste

1 Zuleitung
2 Rückleitung
3, 34 Wässerkühler
4 Bodenplatte
5, 32 Kühlrippen
6, 31 Grundplatte
7 Leistungsmodul
11, 36 Anschlussteil
12, 37 Abschlussteil
13, 38 Kühlerplatte
20 Lüfter
33 Verbindungsmittel zur formschlüssigen Verbindung mit Gehäuseteilen
35 Ausfräsung
41 Kontaktfläche
42 Bohrung
43 Kühlmittelkanal
50, 60 Kühlerplatte
51, 61 Nut
52 Bohrung
53, 63 Anschlussstutzen
54, 64 Erhebung
55 Dichtung
56 Bohrung
57, 67 Nutgrund
68 Oberfläche
69 Durchlass

Die Erfindung wird nun anhand von Abbildungen näher erläutert:

Es zeigt:
- Figur 1 ein elektrisches Gerät mit Luftkühler und montiertem Wasserkühler,
- Figur 2 das elektrische Gerät aus Figur 1 mit zusätzlich montiertem Lüfter,
- Figur 3 ein weiteres elektrisches Gerät mit Luftkühler und montiertem Wasserkühler,
- Figur 4a die mechanische Schnittstelle zur Montage des Wasserkühlers bei dem Gerät nach Figur 1,
- Figur 4b eine Schnittansicht durch das Gerät nach Figur 1,
- Figur 5 eine Prinzipskizze eines Wasserkühlers zur Montage an der mechanischen Schnittstelle des Luftkühlers,
- Figur 6a eine Schrägansicht eines weiteren Wasserkühlers zur Montage an der mechanischen Schnittstelle des Luftkühlers,
- Figur 6b eine Draufsicht auf die der mechanischen Schnittstelle im montierten Zustand zugewandten Seite des Wasserkühlers nach Figur 6a,
- Figur 6c eine Schnittansicht durch den Wasserkühler nach Figur 6a.

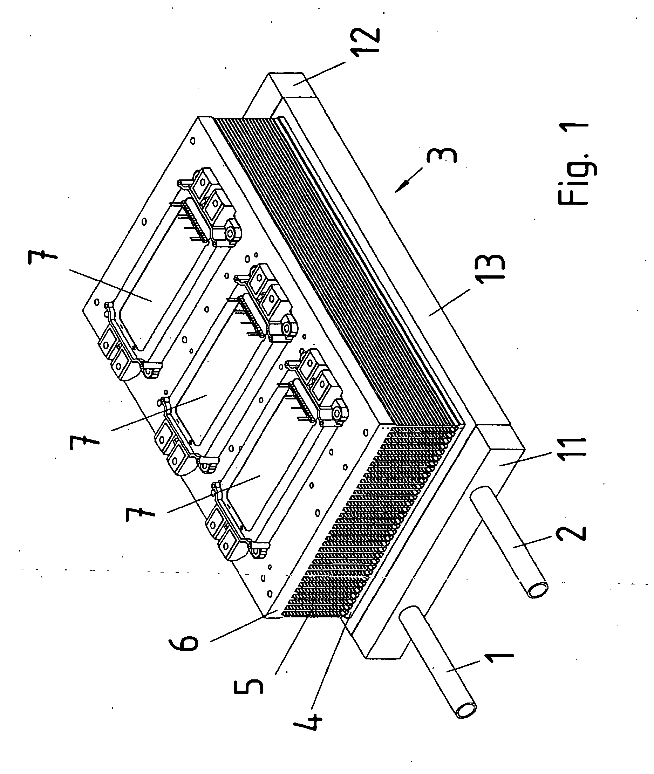

In der Figur 1 ist eine erfindungsgemäße Vorrichtung in Teilen gezeichnet.

Es handelt sich um ein luftkühlbar betreibbares Elektrogerät. Im Elektrogerät sind Wärmequellen, wie beispielsweise elektronische Leistungshalbleiter umfassende Leistungsmodule 7 oder Leistungshalbleiter, deren Wärme an eine Kühlvorrichtung abgeführt wird. Diese umfasst einen Kühlkörper mit Kühlrippen 5.

Im Ausführungsbeispiel nach Figur 1 sind die Kühlrippen 5 zwischen einer Grundplatte 6 und einer Bodenplatte 4 angeordnet.

Der Kühlkörper ist als Strangpressprofil herstellbar, insbesondere aus Aluminium. Somit ist er kostengünstig herstellbar und die Luft kann in Ziehrichtung entlang der Rippen strömen und die Wärme somit aufnehmen.

Insbesondere sind die Kühlrippen 5 als filamentförmige Stranggussprofile ausgebildet, deren obere und untere Seitenbereiche jeweils verdickt ausgeformt sind und die untereinander verpresst und/oder verschweißt werden zur Bildung der Grundplatte 6 aus den oberen Seitenbereichen und der Bodenplatte 4 aus den unteren Seitenbereichen.

Die Bodenplatte 4 ist derart ausgeführt, dass eine mechanische Schnittstelle geschaffen ist zur Montage auf einem Wasserkühler 3, der eine Kühlerplatte 13, ein Anschlussteil 11 und ein Abschlussteil 12 besteht. Die Zuleitung 1 und die Rückleitung 2 für das Wasser sind, wie in Figur 1 sichtbar, am Anschlussteil 11 angebracht..

Somit ist das Gerät in einer ersten kostengünstigeren Betriebsart in nur luftgekühlter Weise einsatzfähig und in einer zweiten aufwendigeren Betriebsart in wassergekühlter Weise betriebsfähig.

In der ersten Betriebsart wird das Gerät mittels seiner Bodenplatte an eine Wand, beispielsweise Schaltschrank-Innenwand oder Maschinenwand, anmontiert, mit Luft gekühlt und hat nur eine erste maximal zulässige Leistung.

In der zweiten Betriebsart wird das gleiche Gerät mittels seiner Bodenplatte an den Wasserkühler 3, also die Kühlerplatte 13, anmontiert und mit dessen Unterseite dann an eine Wand, beispielsweise Schaltschrank-Innenwand oder Maschinenwand, anmontiert und hat nur eine zweite maximal zulässige Leistung, die weit größer ist als die erste Leistung, wenn die Wasserkühlung und die Luftkühlung gleichzeitig betrieben wird. Wenn nur die Wasserkühlung betrieben wird, fließt die Wärme von den Wärme erzeugenden Komponenten durch den Kühlkörper zur Luftkühlung hindurch zum Wasserkühler hin und wird dann mit dem diesen durchströmenden Wasser abgeführt.

Somit kann dieselbe Elektronik und dasselbe Gehäuse des Gerätes verwendet werden für zwei verschiedene Leistungsklassen, wobei in der höheren Leistungsklasse nur ein zusätzlicher Wasserkühler vorgesehen werden muss. Weiter wesentlich ist aber auch, dass bei bloßer Wasserkühlung zwar keine höhere Leistungsklasse erreichbar ist, aber die Wärme nicht an die das Gerät direkt umgebende Luft abgeführt wird sondern über den Wasserkühler.

Mit der Erfindung ist es also ermöglicht, ein luftkühlbares Gerät statt über Luft auch mit Wasser zu kühlen, indem ein Wasserkühler anmontierbar ist. Wichtig ist dabei, dass in dem

Fall des anmontierten Wasierkühlers die Wärme durch den Kühlkörper des Luftkühlers hindurchfließt zum Wasserkühler.

Wichtig ist auch, dass an der Berührfläche zwischen Wasserkühler und Bodenplatte des Kühlkörpers, also Luftkühlers, eine mechanische Schnittstelle vorgesehen ist, also die beiden Teile miteinander verbindbar sind.

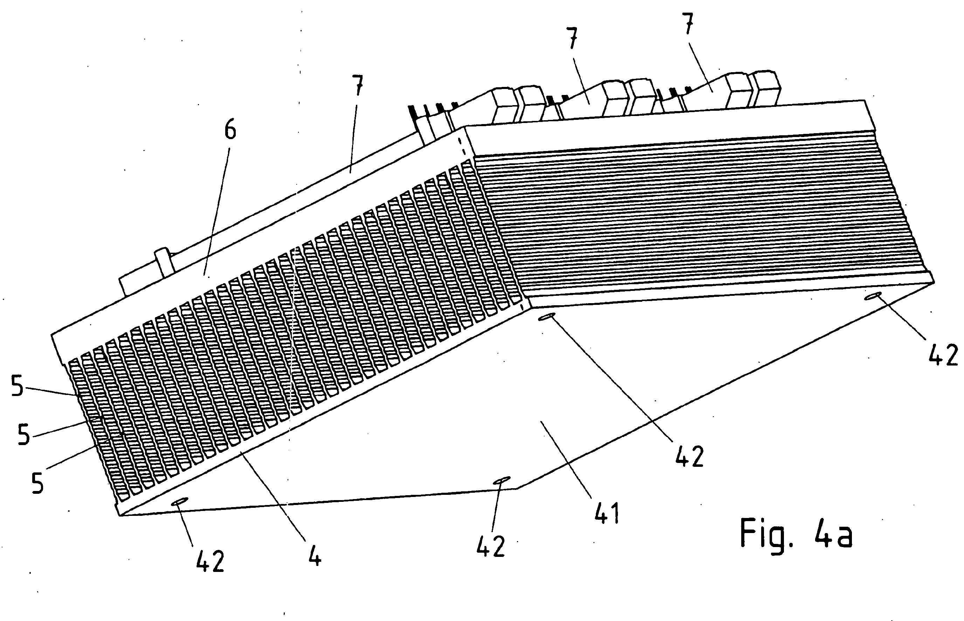

Figur 4a zeigt das luftkühlbare Gerät aus Figur 1, wobei der Wasserkühler abmontiert wurde. Leistungsmodule 7 sind auf einer Grundplatte 6 montiert. An der Verbindungsfläche zwischen Leistungsmodulen 7 und Grundplatte 6 ist Wärmeleitpaste aufgebracht.

Die Grundplatte 6 mündet in Kühlrippen 5. Somit ist ein Luftkühler für die Leistungsmodule 7 ausgebildet. Zwischen den Kühlrippen 5 und den Leistungsmodulen 7 ist somit für jedes Leistungsmodul 5 ein Wärme-Weg, also eine Wärmebrücke, für die abfließende Wärme gebildet, der nur eine Stoffgrenze - die Verbindungsfläche zwischen dem Leistungsmodul 7 und der Grundplatte 6 - überquert. Somit ist ein Luftkühler mit hoher Kühlleistung bereitgestellt.

Die von der Grundplatte 6 abgewandten Enden der Kühlrippen 5 sind jeweils mit einer Bodenplatte 4 einstückig verbunden.

Die von den Kühlrippen 5 abgewandte Seite der Bodenplatte 4 weist eine plane Kontaktfläche 41 auf. Die Kontaktfläche 41 ist derart bearbeitet, dass eine Montage eines Wasserkühlers ermöglicht ist, wobei der Wärmeübergangswiderstand zwischen Kontaktfläche 41 und Wasserkühler gering ist. Insbesondere ist die Kontaktfläche besonders plan und die Oberflächengüte wie durch Schleifen mit besonderer Sorgfalt oder besser erreichbar.

Die Bodenplatte 4 weist Bohrungen 42 auf, in die zur Montage eines Wasserkühlers Schrauben geschraubt werden. Der verwendete Wasserkühler weist eine zur Kontaktfläche 41 passend ausgebildete Kontaktfläche auf. Somit ist an dem Übergang zwischen den Kontaktflächen ein geringer Wärmeübergangswiderstand erreicht. Dieser Wärmeübergangswiderstand ist durch den Einsatz von Wärmeleitpaste zwischen den Kontaktflächen nochmals reduziert.

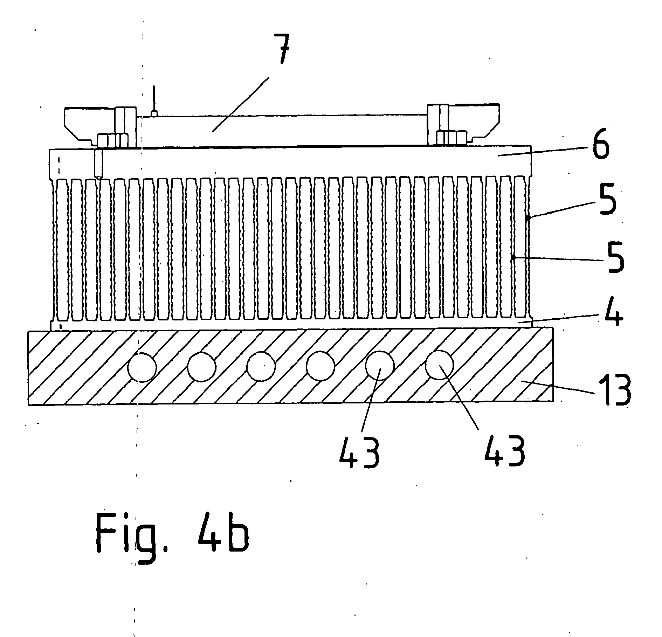

Figur 4b zeigt den Luftkühler aus Figur 4a mit anmontiertem dreistückig ausgeführtem Wasserkühler 3. Dieser Wasserkühler 3 umfasst eine Kühlerplatte, in der parallel verlaufende Kühlmittelkanäle 43 vorgesehen sind zur Durchleitung einer Kühlflüssigkeit. Diese Kühlmittelkanäle 43 sind über ein Anschlussteil 11 und ein Abschlussteil 13 an ihren jeweiligen Enden paarweise miteinander verbunden zur Bildung eines mäanderförmig verlaufenden Kühlmittelkanals. Dazu sind im Anschlüssteil 11 und im Abschlussteil 13 entsprechende Ausnehmungen vorgesehen. Der Wasserkühler 3 ist somit betreibbar, indem der Kühlmittelkanal an einen Kühlmittelkreislauf angeschlossen.

Bei einem alternativen Ausführungsbeispiel sind die parallel in der Kühlerplatte verlaufenden Kühlmittelkanäle über an den Mündungsseiten der Kühlmittelkanäle angebrachte Anschlussteile derart verbunden, dass eine Parallelschaltung der Kühlmittelkanäle entsteht. An einem Anschlussteil ist in dieser Ausführung eine Zuleitung vom Kühlmittelkreislauf vorgesehen, während an dem anderen Anschlussteil eine Rückleitung zum Kühlmittelkreislauf vorgesehen ist.

Anschlussteile und gegebenenfalls Abschlussteile sind mit der Kühlerplatte stoffschlüssig verbunden und/oder durch ein Schienensystem und/oder ein Nutensystem formschlüssig gehalten. In alternativen sind lösbare Verbindungen der drei Teile des Wasserkühlers vorgesehen.

In einer Weiterbildung sind die Bohrungen 42 zusätzlich von der den Kühlrippen 5 zugewandten Seite zugänglich. Somit sind die Bohrungen 42 zur Montage des Luftkühlers an einer Wand einsetzbar, beispielsweise durch Verwendung von Schrauben, deren Gewindedurchmesser kleiner als die lichte Weite der Bohrungen 42 ist.

In einem weiteren Ausführungsbeispiel ist die Bodenplatte nicht eben ausgeführt, sondern sie weist eine andere geometrische Form auf, die einen gut wärmeleitenden Kontakt zu den Wärme erzeugenden Komponenten bewirkt.

Bei einem weiteren Ausführungsbeispiel sind die Anschlussstutzen nicht seitlich der Kühlerplatte sondern an deren Rückseite angebracht. Alternativ sind die Anschlussstutzen an verschiedenen Seiten der Kühlerplatte angebracht.

Bei einem weiteren Ausführungsbeispiel sind die Anschlussstutzen als Gewindebohrlöcher ausgeführt, in welche Kühlleitungen zum Anschluss an eine Kühlmittelanlage einschraubbar sind.

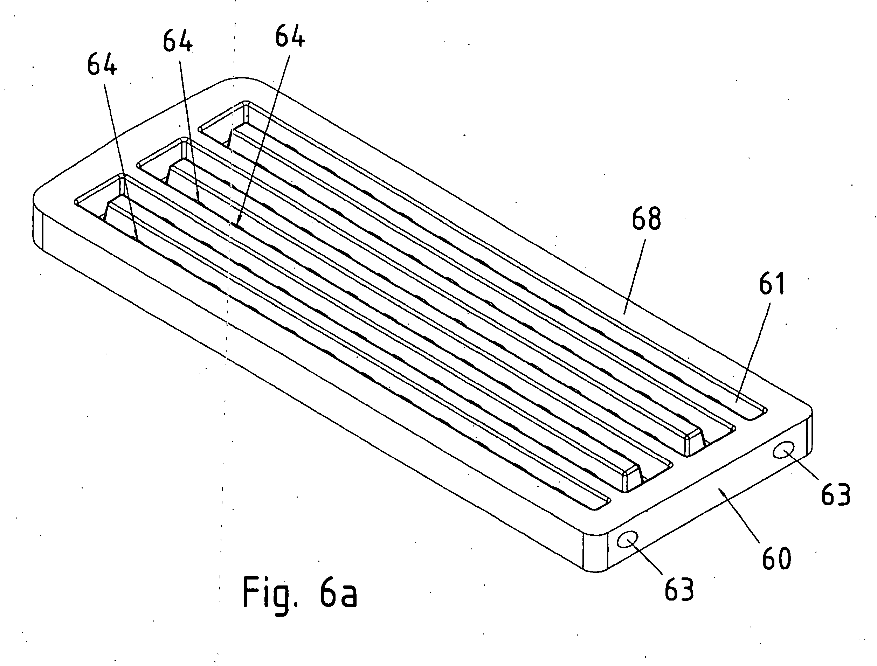

Figur 6a zeigt ein weiteres Ausführungsbeispiel eines erfindungsgemäßen Wasserkühlers, der mit einer Bodenplatte 4 eines Luftkühlers verbindbar ist. Eine Kühlerplatte 60 weist eine Nut 61 auf, die in Anschlussstutzen 63 zum Anschluss eines Kühlkreislaufs münden. Die Kühlerplatte 60 weist weiter eine plane, geschliffene Oberfläche 68 auf, die eine mechanische Schnittstelle zur Bodenplatte 4 des Luftkühlers ausbildet. Diese mechanische Schnittstelle wird zur Montage des Wasserkühlers an die ebenfalls plan ausgebildete Fläche der Bodenplatte 4 mittels Schrauben angepresst. Dabei sind die Schrauben in regelmäßigen Abständen, vorzugsweise einem Abstand zwischen 2 cm und ungefähr 15 cm zur Erzeugung eines gleichmäßigen Anpressdruckes und einer sicheren Abdichtung, angeordnet. Dadurch wird die Nut 61 verschlossen, und es ist ein geschlossener Kühlmittelkanal gebildet, der die Anschlussstutzen 63 verbindet und insbesondere zur Durchleitung von Kühlmittelflüssigkeit geeignet sind.

Größere Abstände der Schrauben sind je nach Materialbeschaffenheit der Kühlerplatte, insbesondere je nach Elastizität, bei alternativen Weiterbildungen vorgesehen.

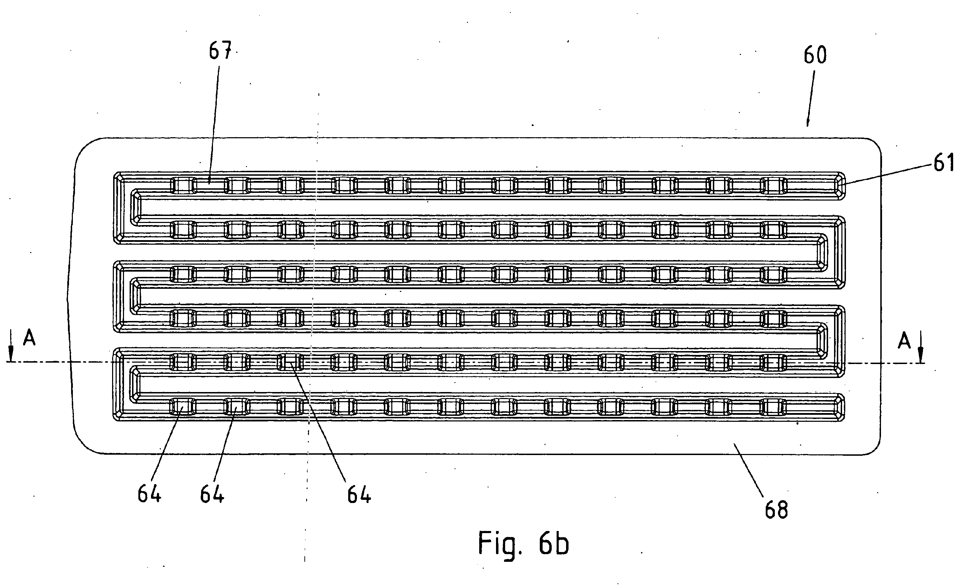

Figur 6b zeigt den Wasserkühler in Draufsicht auf die geschliffene Oberfläche 68 und den Nutgrund 67 mit den Erhebungen 64.

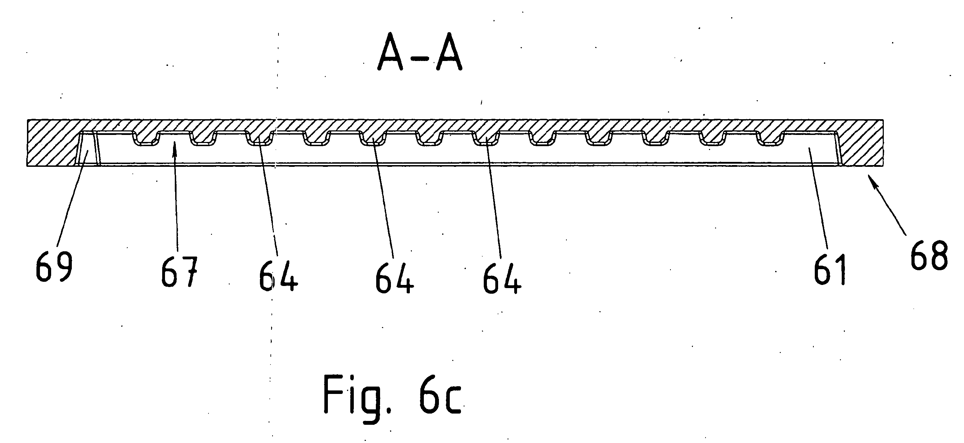

Figur 6c zeigt einen Schnitt entlang der Linie A-A aus Figur 6b. Der gezeigte Abschnitt der Nut 61 ist über einen Durchlass 69 mit dem benachbarten Abschnitt der Nut 61 verbunden, so dass eine mäanderförmig verlaufende Nut 61 gebildet ist, wie sie die Figuren 6a und 6b zeigen. Die Erhebungen 64 sind in regelmäßigen Abständen angeordnet und weisen eine Höhe auf, die geringer als die halbe Tiefe der Nut 61 ist. Die Abstände der Erhebungen 64 voneinander sind größer gewählt als die Längsausdehnung, also die Ausdehnung in Nutrichtung, der Erhebungen 64.

In einer alternativen Ausbildung sind die Erhebungen in unregelmäßigen Anordnungen angeordnet und/oder weisen eine unregelmäßige Verteilung der einzelnen Längsausdehnungen auf.

In einer Weiterbildung weist die Bodenplatte zusätzlich Zentriermittel wie Nuten, Nasen und/oder Stufen auf, und der Wasserkühler weist dazu passend ausgebildete Zentriermittel auf. Somit ist eine leichte Montage in definierter Relativposition von Wasserkühler und Luftkühler ermöglicht. Vorzugsweise sind die Zentriermittel derart ausgeführt, dass eine Belastung der Schrauben zur Verbindung des Wasserkühlers mit dem Luftkühler auf Scherung vermieden wird. In einer Alternative oder Weiterbildung weist die Kühlerplatte des Wasserkühlers derartige Zentriermittel auf, und die Bodenplatte des Luftkühlers ist zu diesen entsprechend ausgebildet.

In einem alternativen Ausführungsbeispiel ist der Wasserkühler mittels einer Spannvorrichtung an der Bodenplatte des Luftkühlers montierbar. Die Spannvorrichtung umfasst insbesondere Bügel, Hebel und Haken, wobei zum Spannen die Bügel in Haken eingelegt werden und durch Umlegen eines jeweils mit einem der Bügel verbundenen Hebels der Wasserkühler an die Bodenplatte 4 angepresst wird. Somit ist eine schnelle Montagemöglichkeit bereitgestellt. Andere Befestigungsmittel, beispielsweise Klemmbügel oder Einrastmechanismen, zur Befestigung der Kühlerplatte an der Bodenplatte sind bei Weiterbildungen vorgesehen.

In einem alternativen Ausführungsbeispiel wird der Wasserkühler mit einer Seite in eine In einem alternativen Ausführungsbeispiel wird der Wasserkühler mit einer Seite, in eine nutförmige Ausnehmung der Bodenplatte eingesetzt und mit der anderen Seite an der Bodenplatte lösbar befestigt, beispielsweise über eine Spannvorrichtung der beschriebenen Art oder über eine Schraubverbindung.

In weiteren Ausführungsbeispielen ist die mechanische Schnittstelle zwischen Bodenplatte und Kühlerplatte nicht als Ebene ausgebildet, sondern es ist eine andere geometrische Form vorgesehen, mit der ein gut wärmeleitender Kontakt zwischen Bodenplatte und Kühlerplatte bewirkt ist. Beispielsweise verläuft die mechanische Schnittstelle entlang eines Abschnitts einer gedanklichen Kugelschale.

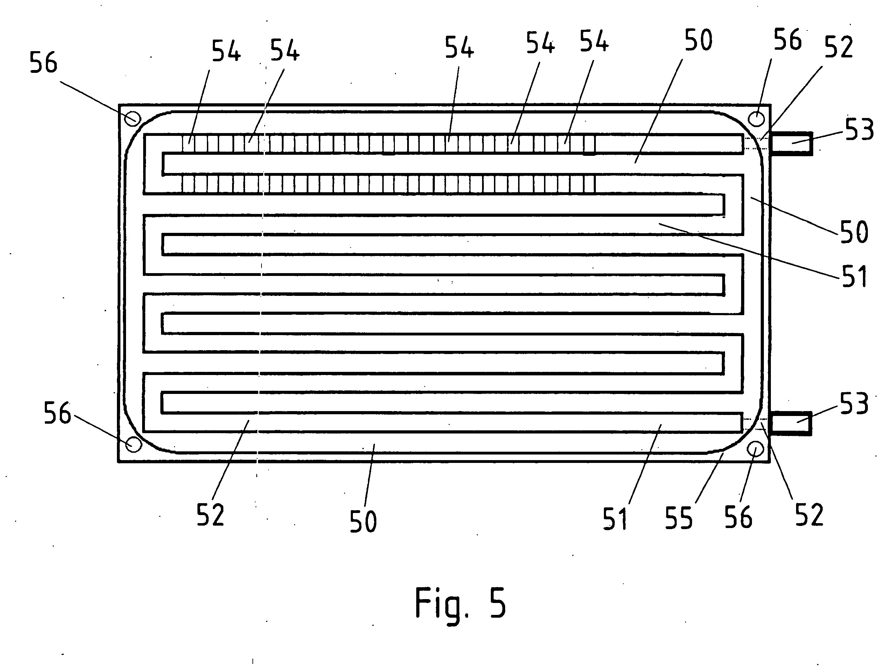

Figur 5 zeigt ein alternatives Ausführungsbeispiel eines Wasserkühlers. Dargestellt ist eine Prinzipskizze der Draufsicht auf die Fläche des Wasserkühlers, die zur Verbindung mit der Bodenplatte des Luftkühlers bestimmt ist.

Der Wasserkühler umfasst eine Kühlerplatte 50, in der eine Nut 51 mäanderförmig ausgebildet sind. Diese Nut 51 mündet an ihren Enden in Bohrungen 52, die ihrerseits in Anschlussstutzen 53 enden. Ein Kühlkreislauf ist über die Anschlussstutzen 53 mit dem Wasserkühler verbindbar.

Wird die Kühlerplatte 50 mit ihrer Nutseite an der Bodenplatte 4 des Luftkühlers befestigt, so ist mit der nun verschlossenen Nut 51 ein geschlossener Kanal gebildet, der die Anschlussstutzen 53 verbindet. Somit ist der Wasserkühler in montierter Position betriebsbereit und kann über die Anschlussstutzen mit Kühlflüssigkeit, beispielsweise Wasser, beschickt werden.

Durch die unvollständige Ausbildung des Kühlmittelkanals im Wasserkühler sind die Fertigungskosten für den Wasserkühler reduzierbar.

Bohrungen 56 in der Kühlerplatte 50 nehmen Schrauben auf, über die der Wasserkühler mit der Bodenplatte 4 des Luftkühlers verbindbar ist.

Die Kühlerplatte 50 weist Dichtungsmittel in Form einer umlaufenden Dichtung 55 auf. Diese Dichtung 55 ist in einer Weiterbildung in eine nichtgezeigte Nut eingelegt oder als Loctite-Klebestreifen ausgeführt. Vorteil der Verwendung einer Nut ist, dass ein eingelegter O-Ring beim Montieren des Wasserkühlers in definierter Weise verquetscht wird. Somit ist der O-Ring vor unsachgemäßer Benutzung und daraus folgender Zerstörung geschützt, und es ist ein sichere, robuste Dichtung bereitgestellt.

Der Wasserkühler, insbesondere die Kühlerplatte, ist vorzugsweise im Aluminiumgussverfahren hergestellt.

Bei alternativen Ausführungsbeispielen ist der Wasserkühler aus Kupfer hergestellt.

Bei einer vorteilhaften Weiterbildung weist der Nutgrund 57 der Nut 51 Erhebungen 54 auf. Diese Erhebungen 54 bewirken eine Verwirbelung des vorbeiströmenden Kühlmittels und somit eine erhöhte Kühlleistung.

Bei einer Weiterbildung weist die Bodenplatte Erhebungen auf, die in die nutförmigen Ausnehmungen der Kühlerplatte passen und diese teilweise ausfüllen. Somit sind die Ausnehmungen dicht verschlossen, und es ist ein Kühlmittelkanal gebildet. Die Erhebungen der Bodenplatte bewirken zusätzlich eine Zentrierhilfe beim Aufsetzen der Kühlerplatte auf die Bodenplatte und entlasten in montiertem Zustand die Befestigungsmittel. Die geometrische Ausformung der Erhebungen ist vorzugsweise derart ausgeführt, dass durch die Anpressung der Kühlerplatte an die Bodenplatte ein dichtender Abschluss der Kühlmittelkanäle bewirkt ist.

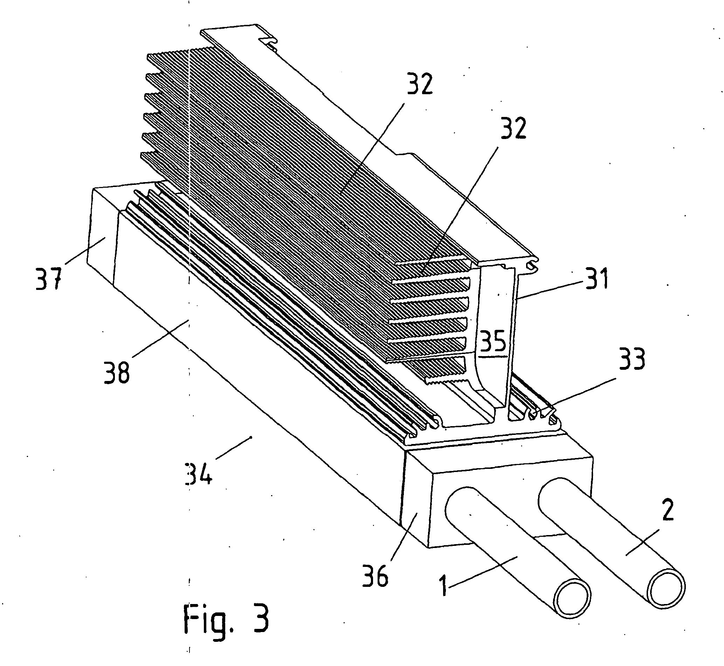

In dem alternativen Ausführungsbeispiel nach Figur 3 ist wiederum ein Wasserkühler 34 vorgesehen, der an der Grundplatte 31 selbst anmontierbar ist. Diese ist dazu derart T-förmig ausgeführt, dass der Wasserkühler seitlich anbringbar ist. Die Grundplatte 31 umfasst, dabei nicht nur die Kühlrippen 32 sondern auch Verbindungsmittel 33 zur formschlüssigen Verbindung mit Gehäuseteilen, also eine weitere mechanische Schnittstelle. Wärme erzeugende Komponenten, insbesondere Leistungshalbleiter, sind an der Rückseite der Grundplatte 31 angebracht. Werden metallische Gehäuseteile eingesetzt, kann ein weiterer . Teil der Wärme auch über diese in die Umgebung abfließen. Die Grundplatte ist selbst auch zumindest teilweise gehäusebildend.

Der Wasserkühler ist dreiteilig ausgeführt, wobei im Inneren einer Kühlerplatte 38 Kühlmittelkanäle vorgesehen sind, und an den Stirnseiten ein Anschlussteil 36 und ein Abschlussteil 37 angebracht ist. Das Anschlussteil 36 verbindet die Kühlmittelkanäle untereinander und mit einer Zuleitung 1 und einer Rückleitung 2 eines Kühlmittelkfeislaufs. Das Abschlussteil 37 verbindet die Kühlmittelkanäle untereinander. Kühlerplatte 38, Abschlussteil 37 und Anschlussteil 36 sind miteinander stoffschlüssig, insbesondere durch Schweißen oder Kleben, verbunden.

Eine Ausfräsung 35 ist zur Aufnahme eines Lüfters vorgesehen. Somit ist eine weitere Variante bildbar, bei der die Kühlleistung des Luftkühlers mittels Lüfter gesteigert ist..

Bei einer alternativen Ausführungsform ist der Wasserkühler einstückig ausgeführt.

In einem ersten erfindungsgemäßen Ausführungsbeispiel ist das Gerät ein Umrichter für industrielle Anwendungen, Er versorgt einen Elektromotor und steuert diesen. Hierzu weist der Umrichter Signalelektronik auf, die mit einer Wärmesperre zur Leistungselektronik ausgeführt ist. Die Wärmesperre kann einerseits durch ein Wärme schlechter als Metall leitendes Material sein und/oder durch entsprechend vorgesehene Luftbewegung, also ein Trennen der die Leistungselektronik und der die Signalelektronik berührenden Luftströmungen.

In einem anderen erfindungsgemäßen Ausführungsbeispiel-ist das Gerät zur Einspeisung eines mittelfrequenten Stromes in eine Primärleitersystem, an dem bewegbar angeordnete Verbraucher vorgesehen sind, die aus an das Primärleitersystem induktiv angekoppelten Sekundärspulen versorgbar sind.

In einem anderen erfindungsgemäßen Aüsführungsbeispiel ist das Gerät ein Sanftanlaufgerät oder ein Motorstromschaltendes Gerät oder eine Steuerung mit Leistungsstufe. Alternativ ist das Gerät ein Elektrogerät, wie beispielsweise eine unterbrechungsfreie Stromversorgung, also Notstromaggregat oder dergleichen, oder Frequenzumformer oder Wechselrichter.

In einem erfindungsgemäßen Ausführungsbeispiel wird das Gerät in seinem Schaltschrank oder einem anderen luftabgeschlossenen Raumbereich vorgesehen. Hierbei übernimmt der Kühlkörper mit Kühlrippen 5 eine weitere Funktion, nämlich die Kühlung der das Gerät umgebenden Luft, beispielsweise also die Innenluft im Schaltschrank. Somit sind auch weitere elektronische Geräte, die im Schaltschrank vorgesehen sind, kühlbar mittels der über die Kühlrippen an den Wasserkühler abführbaren Wärme.

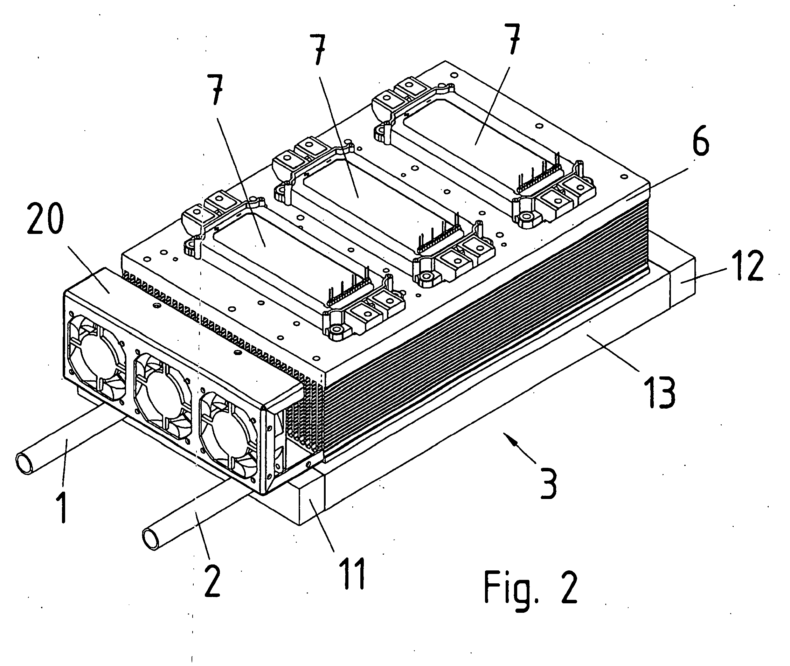

Wie in Figur 2 gezeigt, ist in einem anderen erfindungsgemäßen Ausführungsbeispiel ein elektromotorisch angetriebener Lüfter 20 derart vorgesehen, dass die Luftströmung entlang der Kühlrippen aktiv antreibbar und/oder steuerbar ist. Somit ist in der ersten Betriebsart eine höhere maximal zulässige Leistung erreichbar, da die Luft nicht nur konvektiv angetrieben strömt sondern viel mehr Luftmenge pro Zeit hindurchströmt durch den Luftkühler. In der zweiten Betriebsart ist ebenfalls eine etwas, höhere Leistung erreichbar. Alternativ ist aber die Umgebungsluft des Gerätes mit abkühlbar, also sind auch andere Geräte kühlbar.

Der Lüfter 20 nach Figur 2 ist mit zwei weiteren Lüftern in einem Lüftermodul angeordnet, das kraft- und /oder formschlüssig verbindbar ist mit dem Kühler, insbesondere den Rippen 5 des Kühlers.

In einem weiteren erfindungsgemäßen Ausführungsbeispiel ist die Wärme der Signalelektronik des Gerätes abführbar an die Umgebung. Dies kann direkt oder indirekt über einen Kühlkörper erfolgen. Somit-ist, wenn das Gerät in einem Schaltschrank oder geschlossenen Raumbereich montiert ist, die Signalelektronik wiederum über die umgebende Luft und diese wiederum über die Kühlrippen des Luftkühlers des Geräts kühlbar, da dieser vom Wasserkühler gekühlt ist.

In einem weiteren erfindungsgemäßen Ausführungsbeispiel ist der Wasserkühler mechanisch elastischer ausgeführt also der die Kühlrippen 5 umfassende Luftkühler. Außerdem sind die Mittel zur lösbaren Verbindung des Wasserkühlers mit dem Luftkühler derart ausgeführt, dass die Platte 3 eben an die Bodenplatte 4 beim Verbinden angelegt wird. Zwischen den beiden Platten kann Wärmeleitpaste oder -folie vorgesehen sein. Die Mittel umfassen Verbindungsschrauben, die durch den Luftkühler geführt sind und am Wasserkühler anschraubbar sind. Alternativ sind als Verbindungsmittel Spannmittel vorgesehen, die derart angeordnet sind, dass die elastischere Platte 3 an die bodenplatte 4 angedrückt-wird, wobei ein möglichst gleichmäßiges Anliegen erreicht wird. In Weiterbildung umfassen die Spannmittel Spannhaken oder andere Spannelemente

In einem anderen erfindungsgemäßen Ausführungsbeispiel ist der Kühlkörper im Unterschied zu Figur 1 aus einem Kupfer-Walzprofil hergestellt.

Die Merkmale des Kühlsystems nach der anhängigen Patentanmeldung DE 10 2006 020 801 sind vorteilhaft mit den Merkmalen der hier vorgestellten Kühlvorrichtung aus Luftkühler und Wasserkühler kombinierbar. Hierzu wird auf diese DE 10 2006 020 801 verwiesen, deren diesbezügliche Offenbarung in den Inhalt der vorliegenden Beschreibung, insbesondere als Ausführungsbeispiele und Weiterbildung des hier beschriebenen Kühlsystems aufgenommen wird.

## Patentansprüche

1. Elektrisches Gerät, insbesondere ein Umrichter,
umfassend Wärme erzeugende elektrische Leistungshalbleiter (7) und eine Kühlvorrichtung zur Abfuhr dieser Wärme.
wobei die Kühlvorrichtung aus einem Luftkühler (4, 5, 6) gebildet ist, an dem ein Flüssigkeitskühler (13) anmontiert ist,
wobei der Flüssigkeitskühler (13) vorgesehen wird zur Erhöhung der Kühlleistung, derart, dass der Luftkühler (4, 5, 6) einen wesentlichen Anteil , insbesondere 90% oder mehr, der von den Wärme erzeugenden Komponenten aufgenommenen Warme hindurchleitet an den' Flüssigkeitskühler (13),
**dadurch gekennzeichnet, dass**
der Luftkühler (4, 5, 6) zwischen dem Flüssigkeitskühler (13) und den Wärme erzeugenden elektrischen Leistungshalbleitern (7) vorgesehen ist.

2. Gerät nach Anspruch 1
**dadurch gekennzeichnet, dass**
wobei der Luftkühler einen Kühlkörper umfasst, der Rippen und/oder Finger aufweist zur Wärmeabgabe an vorbeiströmende Luft,
und die Wärme erzeugenden elektrischen Komponenten auf, in oder an einer Grundplatte (6, 31) verbunden sind, insbesondere wärmeleitend,
wobei die Grundplatte (6, 31) mit dem Kühlkörper einstückig ausgebildet ist,
und der Kühlkörper eine mechanische Schnittstelle zum lösbaren Verbinden mit einem Flüssigkeitskühler (13) aufweist.

3. Gerät nach mindestens einem der vorangegangenen Ansprüche
**dadurch gekennzeichnet, dass**
die mechanische Schnittstelle eine Bodenplatte (4) umfasst zur Montage des Flüssigkeitskühlers (13),
insbesondere wobei an der Bodenplatte (4) ein Wasserkühler (3, 34) montiert ist.

4. Gerät nach mindestens einem der vorangegangenen Ansprüche,
**dadurch gekennzeichnet, dass**
der Wasserkühler (3, 34) eine Kühlerplatte (13, 38) umfasst, in der parallel verlaufende Kühlmittelkanäle ausgebildet sind, die vorzugsweise durch Anschlussteile oder Abschlussteile zu einem Kühlmittelkanalsystern verbunden sind, insbesondere wobei die Kühlmittelkanäle als Bohrung oder als Nut ausgebildet sind.

5. Gerät nach mindestens einem der vorangegangenen Ansprüche,
**dadurch gekennzeichnet, dass**
der Wasserkühler (3, 34) eine Kühlerplatte (13, 38) umfasst, in der Ausnehmungen zur Aufnahme und Durchleitung einer Kühlflüssigkeit ausgebildet sind,
wobei die Bodenplatte (4) des Luftkühlers (4, 5, 6) zumindest teilweise gehäusebildend für die Ausnehmungen ist.

6. Gerät nach mindestens einem der vorangegangenen Ansprüche,
**dadurch gekenntzeichnet, dass**
die Ausnehmungen der Kühlerplatte (13, 38) als mäanderförmige Nut ausgebildet sind, die in seitlich oder in der Rückwand der Kühlerplatte (13, 38) angebrachte Anschlussvorrichtungen, insbesondere Anschlussstutzen, zum Anschluss an eine Kühlmittelanlage münden

7. Gerät nach mindestens einem der vorangegangenen Ansprüche,
**dadurch gekennzeichnet, dass**
die Bodenplatte (4) Erhebungen aufweist, die zu den Ausnehmungen der Kühlerplatte (13, 38) passend ausgebildet sind, insbesondere zum dichtenden abschluß der Ausnehmungen und/oder als Zentrierhilfe.

8. Gerät nach mindestens einem der vorangegangenen Ansprüche,
**dadurch gekennzeichnet, dass**
die Bodenplatte (4) über die Kühlrippen (5, 32) und/oder Kühlfinger von der Grundplatte (6, 31) beabstandet ausgebildet ist.

9. Gerät nach mindestens einem der vorangegangenen Ansprüche,
**dadurch gekennzeichnet, dass**
an der Grundplatte (6, 31) des Kühlkörpers einerseits Kühlrippen (5, 32) und/oder Kühlfinger ausgebildet sind und andererseits eine Bodenplatte (4) zum Herstellen einer Verbindung mit der Bodenplatte (4) vorgesehen ist, insbesondere wobei Bodenplatte (4) und Grundplatte (6, 31) einstückig ausgebildet sind

10. Gerät nach mindestens einem der vorangegangenen Ansprüche,
**dadurch gekennzeichnet; dass**
die Grundplatte (6, 31) mit den Kühlrippen (5, 32) oder mit Kühlfingern einstückig ausgebildet ist.

11. . Gerät nach mindestens einem der vorangegangenen Ansprüche,
**dadurch gekennzeichnet, dass**
der Kühlkörper und/oder die Kühlerplatte (13, 38) als Strangpressprofil oder Druckguss fertigbar ist.

12. Gerät nach mindestens einem der vorangegangenen Ansprüche,
**dadurch gekennzeichnet, dass**
der Kühlkörper Kühlrippen (5, 32) zwischen einer Grundplatte (6, 31) und einer Bodenplatte (4) umfasst, welche zur Verbindung mit dem Wasserkühler (3, 34) vorgesehen ist.

13. Gerät nach mindestens einem der vorangegangenen Ansprüche,
**dadurch gekennzeichnet, dass**
der Kühlkörper Kühlrippen (5, 32) auf einer Grundplatte (6, 31) umfasst, an der eine Bodenplatte (4) angebracht oder einstückig ausgeformt ist, welche zur Verbindung mit dem Wasserkühler (3, 34) vorgesehen ist.

14. Gerät nach mindestens einem der vorangegangenen Ansprüche,
**dadurch gekennzeichnet, dass**
ein Lüfter (20) zum Erzeugen von Luftströmung entlang der Rippen des Kühlkörpers vorgesehen ist.

15. Gerät nach mindestens einem der vorangegangenen Ansprüche,
**dadurch gekennzeichnet, dass**
das Gerät in einem geschlossenen Raumbereich vorgesehen ist, so dass Wärme aus der Luft des Raumbereiches zusammen mit der Wärme der Komponenten über die Rippen und den Wasserkühler (3, 34) abführbar ist.

16. Gerät nach mindestens einem der vorangegangenen Ansprüche,
**dadurch gekennzeichnet, dass**
im Raumbereich weitere Geräte angeordnet sind, die an die Luft des Raumbereiches Wärme abgebende Komponenten aufweisen.

17. Gerät nach mindestens einem der vorangegangenen Ansprüche;
**dadurch gekennzeichnet, dass**
das Gerät eine Steuerung, ein Sanftanlaufgerät, eine unterbrechungsfreie Stromversorgung, ein Notstromaggregat oder ein Frequenzumformer, ein Motorstarter ist, oder eine Motorströme schaltende oder beeinflussende Elektronik aufweist, wobei das Gerät Signalelektronik und Leistungselektronik umfasst.

18. Gerät nach mindestens einem der vorangegangenen Ansprüche,
**dadurch gekennzeichnet, das**
die Grundplatte (6, 31) zusätzlich Verbindungsmittel zur formschlüssigen Verbindung mit Gehäuseteilen umfasst, insbesondere auch zum Abführen von einem Anteil der Wärme an die Umgebung über diese Gehäuseteile.

19. Verfahren zur Kühlung eines Umrichters,
umfassend Wärme erzeugende elektrische Leistungshalbleiter (7) und eine Kühlvorrichtung zur Abfuhr dieser Wärme,
wobei.die Kühlvorrichtung aus einem Luftkühler (4, 5, 6) gebildet ist, an dem ein Flüssigkeitskühler (13) anmontiert ist,
wobei der Flüssigkeitskühler (13) die Kühlleistung derart erhöht, dass der Luftkühler (4, 5, 6) einen wesentlichen Anteil , insbesondere 90% oder mehr, der von den Wärme erzeugenden Komponenten aufgenommenen Wärme hindurchleitet an den Flüssigkeitskühler,
**dadurch gekennzeichnet, dass**
der Luftkühler (4, 5, 6) zwischen dem Flüssigkeitskühler (13) und den Wärme erzeugenden elektrischen Leistungshalbleitern (7) vorgesehen ist.

## Claims

1. An electrical apparatus, in particular a converter, comprising heat-generating electrical power semiconductors (7) and a cooling device to remove this heat, the cooling device being formed of an air cooler (4, 5, 6) on which there is mounted a fluid cooler (13), the fluid cooler (13) being provided to increase the cooling efficiency in such a manner that the air cooler (4, 5, 6) conveys a substantial proportion, in particular 90% or more, of the heat absorbed from the heat-generating components through to the fluid cooler (13), **characterised in that** the air cooler (4, 5, 6) is provided between the fluid cooler (13) and the heat-generating electrical power semiconductors (7).

2. An apparatus according to claim 1, **characterised in that** the air cooler comprising a cooling body with ribs and/or fingers to give off heat to air flowing past, and the heat-generating electrical components being connected on, in or against a mounting plate (6, 31), in particular in a heat-conducting manner, the mounting plate (6, 31) being integral with the cooling body, and the cooling body having a mechanical interface for detachable connection to a fluid cooler (13).

3. An apparatus according to at least one of the preceding claims, **characterised in that** the mechanical interface comprises a base plate (4) for mounting of the fluid cooler (13), in particular a water cooler (3, 34) being mounted on the base plate (4).

4. An apparatus according to at least one of the preceding claims, **characterised in that** the water cooler (3, 34) comprises a cooler plate (13, 38) in which parallel coolant channels, preferably connected by connecting parts or closing parts to form a coolant channel system, are formed, the coolant channels in particular being in the form of a bore or channel.

5. An apparatus according to at least one of the preceding claims, **characterised in that** the water cooler (3, 34) comprises a cooler plate (13, 38) in which there are cutouts for the receipt and through passage of a cooling fluid, the base plate (4) of the air cooler (4, 5, 6) at least partially forming a housing for the cutouts.

6. An apparatus according to at least one of the preceding claims, **characterised in that** the cutouts in the cooler plate (13, 38) are in the form of a meander-shaped channel issuing into connecting devices, in particular connecting branches, which are attached laterally or in the rear wall of the cooler plate (13, 38), for connection to a coolant installation.

7. An apparatus according to at least one of the preceding claims, **characterised in that** the base plate (4) has elevations adapted to the cutouts in the cooler plate (13, 38), in particular to sealingly close the cutouts and/or as a centring aid.

8. An apparatus according to at least one of the preceding claims, **characterised in that** the base plate (4) is at a distance from the mounting plate (6, 31) via the cooling ribs (5, 32) and/or cooling fingers.

9. An apparatus according to at least one of the preceding claims, **characterised in that** on the one hand cooling ribs (5, 32) and/or cooling fingers are formed on the mounting plate (6, 31) and on the other hand a base plate (4) to produce a connection to the base plate (4) is provided, in particular the bottom plate (4) and the mounting plate (6, 31) being formed in one piece.

10. An apparatus according to at least one of the preceding claims, **characterised in that** the mounting plate (6, 31) is in one piece with the cooling ribs (5, 32) or with cooling fingers.

11. An apparatus according to at least one of the preceding claims, **characterised in that** the cooling body and/or the cooler plate (13, 38) can be manufactured as an extruded section or as a pressure casting.

12. An apparatus according to at least one of the preceding claims, **characterised in that** the cooling body comprises cooling ribs (5, 32) between a mounting plate (6, 31) and a base plate (4) provided for connection to the water cooler (3, 34).

13. An apparatus according to at least one of the preceding claims, **characterised in that** the cooling body comprises cooling ribs (5, 32) on a mounting plate (6, 31) on which there is attached or integrally formed a base plate (4) provided for connection to the water cooler (3, 34).

14. An apparatus according to at least one of the preceding claims, **characterised in that** a fan (20) to generate air flow along the ribs of the cooling body is provided.

15. An apparatus according to at least one of the preceding claims, **characterised in that** the apparatus is provided in a closed spatial area so that heat from the air of the spatial area together with the heat of the components can be led away via the ribs and the water cooler (3, 34).

16. An apparatus according to at least one of the preceding claims, **characterised in that** further apparatus are arranged in the spatial area and have components which give off heat to the air of the spatial area.

17. An apparatus according to at least one of the preceding claims, **characterised in that** the apparatus is a control device, a softstarter, an interruption-free current supply, an emergency power generating set or a frequency converter, a motor starter, or has electronics which switch or influence motor currents, the apparatus comprising signal electronics and power electronics.

18. An apparatus according to at least one of the preceding claims, **characterised in that** the mounting plate (6, 31) additionally comprises connecting means for positive-locking connection to housing parts, in particular also for removing a portion of the heat to the environment via these housing parts.

19. A method of cooling a converter, comprising heat-generating electrical power semiconductors (7) and a cooling device to remove this heat, the cooling device being formed of an air cooler (4, 5, 6) on which there is mounted a fluid cooler (13), the fluid cooler (13) increasing the cooling efficiency such that the air cooler (4, 5, 6) conveys a substantial portion, in particular 90% or more, of the heat absorbed from the heat-generating components through to the fluid cooler (13) **characterised in that** the air cooler (4, 5, 6) is provided between the fluid cooler (13) and the heat-generating electrical power semi conductors (7).

## Revendications

1. Appareil électrique, notamment redresseur
comprenant des semi-conducteurs de puissance électrique (7) générant de la chaleur, et un dispositif de refroidissement pour dissiper cette chaleur,
ledit dispositif de refroidissement étant constitué d'un refroidisseur à air (4, 5, 6) sur lequel un refroidisseur à liquide (13) est rapporté,
ledit refroidisseur à liquide (13) étant prévu pour accroître la puissance frigorifique de façon telle que le refroidisseur à air (4, 5, 6) transmette directement, audit refroidisseur à liquide (13), une part notable représentant, en particulier, 90 % ou plus de la chaleur absorbée par les composants générant de la chaleur,
**caractérisé par le fait que**
le refroidisseur à air (4, 5, 6) est prévu entre le refroidisseur à liquide (13) et les semi-conducteurs de puissance électrique (7) générant de la chaleur.

2. Appareil selon la revendication 1,
**caractérisé par le fait que**
le refroidisseur à air englobe un corps de refroidissement muni d'ailettes et/ou de doigts en vue de céder de la chaleur à de l'air en circulation,
et les composants électriques générant de la chaleur sont reliés, notamment avec conduction thermique, sur, dans ou contre une platine de base (6, 31),
ladite platine de base (6, 31) étant réalisée d'un seul tenant avec le corps de refroidissement, et ledit corps de refroidissement comportant un interface mécanique en vue de la liaison amovible avec un refroidisseur à liquide (13).

3. Appareil selon au moins l'une des revendications précédentes,
**caractérisé par le fait que**
l'interface mécanique englobe une platine de fond (4) affectée au montage du refroidisseur à liquide (13),
sachant qu'un refroidisseur à eau (3, 34) est notamment monté sur ladite platine de fond (4).

4. Appareil selon au moins l'une des revendications précédentes,
**caractérisé par le fait que**
le refroidisseur à eau (3, 34) englobe un socle de refroidissement (13, 38) dans lequel sont pratiqués des canaux à fluide de refroidissement qui s'étendent parallèlement et sont rassemblés en un système de canaux à fluide de refroidissement, de préférence par l'intermédiaire de pièces de raccordement ou de pièces d'obturation, lesdits canaux à fluide de refroidissement étant notamment de réalisation du type perçage ou rainure.

5. Appareil selon au moins l'une des revendications précédentes,
**caractérisé par le fait que**
le refroidisseur à eau (3, 34) englobe un socle de refroidissement (13, 38) dans lequel des évidements sont pratiqués en vue de la réception et de la mise en circulation d'un liquide de refroidissement,
la platine de fond (4) du refroidisseur à air (4, 5, 6) formant, au moins en partie, un boîtier destiné auxdits évidements.

6. Appareil selon au moins l'une des revendications précédentes,
**caractérisé par le fait que**
les évidements du socle de refroidissement (13, 38) sont de réalisation du type rainure décrivant des méandres et débouchant dans des dispositifs de raccordement implantés latéralement ou dans la paroi postérieure dudit socle de refroidissement (13, 38), notamment dans des embouts de raccordement, en vue de la liaison avec une installation à fluide de refroidissement.

7. Appareil selon au moins l'une des revendications précédentes,
**caractérisé par le fait que**
la platine de fond (4) offre des protubérances réalisées pour s'adapter aux évidements du socle de refroidissement (13, 38), notamment destinées à l'obturation étanche desdits évidements et/ou remplissant la fonction d'un auxiliaire de centrage.

8. Appareil selon au moins l'une des revendications précédentes,
**caractérisé par le fait que**
la platine de fond (4) est conçue pour être espacée de la platine de base (6, 31) par l'intermédiaire des ailettes de refroidissement (5, 32) et/ou des doigts de refroidissement.

9. Appareil selon au moins l'une des revendications précédentes,
**caractérisé par le fait**
**que**, d'une part, des ailettes de refroidissement (5, 32) et/ou des doigts de refroidissement sont façonné(e)s sur la platine de base (6, 31) et il est prévu d'autre part, sur cette dernière, une platine de fond (4) destinée à instaurer une liaison avec ladite platine de base (6, 31), la platine de fond (4) et la platine de base (6, 31) étant notamment réalisées d'un seul tenant.

10. Appareil selon au moins l'une des revendications précédentes,
**caractérisé par le fait que**
la platine de base (6, 31) est réalisée d'un seul tenant avec les ailettes de refroidissement (5, 32) ou avec des doigts de refroidissement.

11. Appareil selon au moins l'une des revendications précédentes,
**caractérisé par le fait que**
le corps de refroidissement et/ou le socle de refroidissement (13, 38) peut être produit en tant que profilé venu d'extrusion ou en tant que pièce venue de coulée sous pression.

12. Appareil selon au moins l'une des revendications précédentes,
**caractérisé par le fait que**
le corps de refroidissement présente des ailettes de refroidissement (5, 32) entre une platine de base (6, 31) et une platine de fond (4) prévue pour la liaison avec le refroidisseur à eau (3, 34).

13. Appareil selon au moins l'une des revendications précédentes,
**caractérisé par le fait que**
le corps de refroidissement comporte des ailettes de refroidissement (5, 32) sur une platine de base (6, 31) sur laquelle est implantée ou avec laquelle est façonnée, d'un seul tenant, une platine de fond (4) prévue pour la liaison avec le refroidisseur à eau (3, 34).

14. Appareil selon au moins l'une des revendications précédentes,
**caractérisé par**
la présence d'un ventilateur (20) pour engendrer une circulation d'air le long des ailettes du corps de refroidissement.

15. Appareil selon au moins l'une des revendications précédentes,
**caractérisé par le fait que**
ledit appareil est prévu dans une zone spatiale fermée, de sorte que de la chaleur émanant de l'air de ladite zone spatiale peut être évacuée conjointement à la chaleur des composants, par l'intermédiaire des ailettes et du refroidisseur à eau (3, 34).

16. Appareil selon au moins l'une des revendications précédentes,
**caractérisé par**
la présence, dans la zone spatiale, d'appareils supplémentaires munis de composants cédant de la chaleur à l'air de ladite zone spatiale.

17. Appareil selon au moins l'une des revendications précédentes,
**caractérisé par le fait que**
ledit appareil est une commande, un appareil de démarrage en douceur, une alimentation en courant exempte de discontinuité, un groupe électrogène de secours ou un transformateur de fréquence, voire un démarreur de moteur, ou bien présente une électronique commutant ou influençant des courants de moteurs, ledit appareil incluant une électronique génératrice de signaux et une électronique de puissance.

18. Appareil selon au moins l'une des revendications précédentes,
**caractérisé par le fait que**
la platine de base (6, 31) est additionnellement munie de moyens de liaison en vue de la liaison par concordance de formes avec des parties de boîtier, en particulier également en vue d'évacuer une part de la chaleur vers l'espace environnant, par l'intermédiaire de ces parties de boîtier.

19. Procédé de refroidissement d'un redresseur,
comprenant des semi-conducteurs de puissance électrique (7) générant de la chaleur, et un dispositif de refroidissement pour dissiper cette chaleur,
ledit dispositif de refroidissement étant constitué d'un refroidisseur à air (4, 5, 6) sur lequel un refroidisseur à liquide (13) est rapporté,
ledit refroidisseur à liquide (13) accroissant la puissance frigorifique de telle sorte que le refroidisseur à air (4, 5, 6) transmette directement, audit refroidisseur à liquide, une part notable représentant, en particulier, 90 % ou plus de la chaleur absorbée par les composants générant de la chaleur,
**caractérisé par le fait que**
le refroidisseur à air (4, 5, 6) est prévu entre le refroidisseur à liquide (13) et les semi-conducteurs de puissance électrique (7) générant de la chaleur.
